# EUROPÄISCHE PATENTSCHRIFT

(11) **EP 2 017 692 B1**
(45) Veröffentlichungstag und Bekanntmachung des Hinweises auf die Patenterteilung: **28.08.2013**
(21) Anmeldenummer: 08103506.5
(22) Anmeldetag: 11.04.2008
(51) Int. Cl.: G06F 1/18, G11B 33/14

(54) **Computergehäuse**
Computer enclosure
Boîtier d'ordinateur

(30) Priorität: 29.06.2007 DE 102007030123
(43) Veröffentlichungstag der Anmeldung: 21.01.2009
(73) Patentinhaber: Fujitsu Technology Solutions Intellectual Property GmbH, 80807 München (DE)
(72) Erfinder: Neukam, Wilhelm, Bobingen 86399 (DE)
(74) Vertreter: Epping - Hermann - Fischer

(56) Entgegenhaltungen:
- EP-A1- 0 655 882
- EP-A2- 1 377 149
- US-A- 5 347 430
- US-A1- 2005 265 003
- US-B1- 6 307 756
- US-B1- 6 339 536

## Beschreibung

Die Erfindung betrifft ein Computergehäuse, umfassend ein Chassis aus einem elektrisch leitfähigen Material mit wenigstens einer Öffnung und eine Blende aus einem elektrisch nicht leitfähigen Material im Bereich der wenigstens einen Öffnung.

Computergehäuse der oben genannten Art sind vielfach bekannt. Insbesondere weisen die meisten Desktopcomputer im vorderen Bereich ein Anschlussfeld auf, über das Zusatzgeräte wie beispielsweise Mikrofone, Kopfhörer oder Ein-/Ausgabegeräte angeschlossen werden können. Dafür geeignete Anschlüsse sind in der Regel im vorderen Bereich einer Hauptplatine des Computersystems oder auf einer gesonderten Platine angeordnet, die im vorderen Bereich des Computersystems angeordnet ist. Die einzelnen Anschlüsse oder deren Zuleitungen korrespondieren mit einer oder mehreren Öffnungen in dem Chassis des Computergehäuses.

Um eine ansprechende Gestaltung des Computersystems zu ermöglichen und auch um die einzelnen Anschlüsse des Computergehäuses leichter identifizieren zu können, weisen die meisten Computergehäuse eine zusätzlich Blende auf, in die die verschiedenen Baugruppen und Anschlüsse eines Computersystems einheitlich integriert sind. Solche Blenden bestehen in der Regel aus Kunststoff, was eine besonders leichte Bearbeitung und ansprechende Gestaltung ermöglicht.

Moderne Computer arbeiten mit sehr hohen Arbeitsfrequenzen, teilweise im Bereich von mehreren Gigahertz, so dass von ihnen nicht unerhebliche elektromagnetische Störfelder ausgehen. Entsprechend den Bestimmungen zur elektromagnetischen Verträglichkeit (EMV) muss die von einem Computersystem ausgesandte elektromagnetische Strahlung in geeigneter Weise abgeschirmt werden. Hierzu dient in erster Linie ein Chassis aus einem elektrisch leitfähigen Material, insbesondere Stahlblech, das als Farraday'scher Käfig wirkt.

Die Notwendigkeit, Öffnungen in dem Computergehäuse zur Durchführung von Anschlüssen und anderen Bedienelementen vorzusehen, vermindert jedoch deren elektromagnetische Dichtigkeit. Aus diesem Grund sind im Bereich von Öffnungen eines Chassis, insbesondere dem vorderen Anschlussbereich, üblicherweise zusätzliche Abschirmblenden aus gebogenem Blech auf die Vorderwand des Computergehäuses aufgenietet oder aufgeschraubt, um dessen elektromagnetische Dichtigkeit an dieser Stelle wieder herzustellen.

Nachteilig an dem beschriebenen Gehäusekonzept ist jedoch, dass diese zusätzlichen Abschirmblenden an die spezifischen Ein- und Ausgabeelemente eines jeden Computertyps angepasst werden müssen. Darüber hinaus entsteht durch die Verwendung und Installation zusätzlicher Komponenten ein nicht unerheblicher Mehraufwand bei der Herstellung und dem Zusammenbau derartiger Computersysteme.

Aus der EP 1 377 149 A2 ist eine Vorrichtung zum Schutz vor elektrostatischer Entladung und elektromagnetischer Einflüsse auf elektronische Komponenten, in einem Gehäuse, das ein Element, z.B. ein elektrischer Anschluss oder ein Bedienungselement, aufweist bekannt, wobei das Element durch ein I/O-Shield, welches eine Gehäuseöffnung abdeckt, geführt ist und mit einer Dichtungsschicht abgedichtet ist, wobei die Dichtungsschicht so ausgebildet ist, dass mit den Rändern der Gehäuseöffnung elektrischer Kontakt mit der Dichtungsschicht besteht.

Aufgabe der vorliegenden Erfindung ist es, ein Computergehäuse zu beschreiben, bei dem die elektromagnetische Dichtigkeit auf besonders einfache Weise ohne die Verwendung zusätzlicher Abschirmblenden hergestellt werden kann.

Die zugrunde liegende Aufgabe wird erfindungsgemäß durch ein Computergehäuse, umfassend ein Chassis aus einem elektrisch leitfähigen Material mit wenigstens einer Öffnung in einer ersten Seite des Chassis und eine Blende (10) aus einem elektrisch nicht leitfähigen Material im Bereich der wenigstens einen Öffnung gelöst, wobei die Blende vor der ersten Seite des Chassis angeordnet ist.

Dabei weist das Chassis im Bereich der Öffnung wenigstens eine, in Richtung der Blende abstehende Lasche auf und auf einer dem Chassis zugewandten Seite der Blende ist wenigstens eine elektrisch leitfähige Dichtung im Bereich der Öffnung des Chassis angeordnet, wobei die Dichtung im elektrischen Kontakt mit der wenigstens einen Lasche steht, um eine elektrische Schirmung des Computergehäuses im Bereich der Öffnung zu bewirken.

Durch die Verwendung einer abstehenden Lasche einerseits und einer elektrisch leitfähigen Dichtung andererseits kann ein sicherer elektrischer Kontakt zwischen dem Chassis und der Dichtung der Blende hergestellt werden. Durch Aufbringen der elektrisch leitfähigen Dichtung auf die Blende wirkt die vor der Seite des Chassis angeordnete Blende selbst als Abschirmelement, so dass auf die Verwendung zusätzlicher Abschirmblenden verzichtet werden kann.

Gemäß einer vorteilhaften Ausgestaltung umfasst die elektrisch leitfähige Dichtung ein elastisches Schaumstoffteil mit einer elektrisch leitfähigen Oberfläche oder ein elektrisch leitfähiges Polymer-Material. Durch Verwendung einer elastischen Dichtung können Fertigungstoleranzen durch die Flexibilität der Dichtung in einfacher Weise ausgeglichen werden.

Gemäß einer weiteren vorteilhaften Ausgestaltung sind in der Blende und in der elektrisch leitfähigen Dichtung wenigstens eine Öffnung zur Durchführung eines Anschlusses, eines Bedienelementes oder eines Bedienelementes angeordnet, wobei die elektrisch leitfähige Dichtung formschlüssig mit diesem abschließt. Durch ein Vorsehen von Öffnungen in der Blende und der elektrisch leitfähigen Dichtung können Anschlüsse, Anzeigeelemente beziehungsweise Bedienelemente auf einfache Weise durch die Frontblende hindurch geführt werden, so dass diese für einen Benutzer von vorne zugänglich sind. Gleichzeitig kann durch die formschlüssige Gestaltung der elektrisch leitfähigen Dichtung die elektromagnetische Dichtigkeit des Gehäuses bewahrt werden.

Gemäß einer weiteren vorteilhaften Ausgestaltung sind in der Blende und in der elektrisch leitfähigen Dichtung eine Mehrzahl von Öffnungen für eine Mehrzahl von Anschlüssen, Anzeigelementen und/oder Bedienelementen angeordnet und in dem Chassis ist eine einzelne Öffnung zum Durchführen dieser Mehrzahl vorgesehen. Durch die Verwendung einer einzelnen Öffnung auf Seiten des Chassis und einer Mehrzahl von Öffnungen auf Seiten der Blende zum Durchführen einer Mehrzahl von Anschlüssen, Anzeigelementen und/oder Bedienelementen kann ein einzelner Chassistyp für eine Vielzahl von Computersystemen mit unterschiedlichen Anschlusselementen im Bereich der Blende eingesetzt werden. Auf diese Weise ist eine einfache Variation des Computergehäuses durch Anpassen der Blende allein möglich.

Weitere vorteilhafte Ausgestaltungen der Erfindung sind in den Unteransprüchen angegeben.

Die Erfindung wird nachfolgend anhand von Ausführungsbeispielen unter Bezugnahme auf Figuren näher erläutert. In den Figuren zeigen:
- Figur 1: eine perspektivische Ansicht eines Computergehäuse gemäß dem Stand der Technik,
- Figur 2: eine perspektivische Ansicht eines Computergehäuses gemäß einer Ausgestaltung der Erfindung,
- Figur 3: eine perspektivische Ansicht einer Blende mit einer darauf angeordneten elektrisch leitfähigen Dichtung und
- Figur 4: einen Querschnitt durch ein Computergehäuse gemäß einer Ausgestaltung der Erfindung.

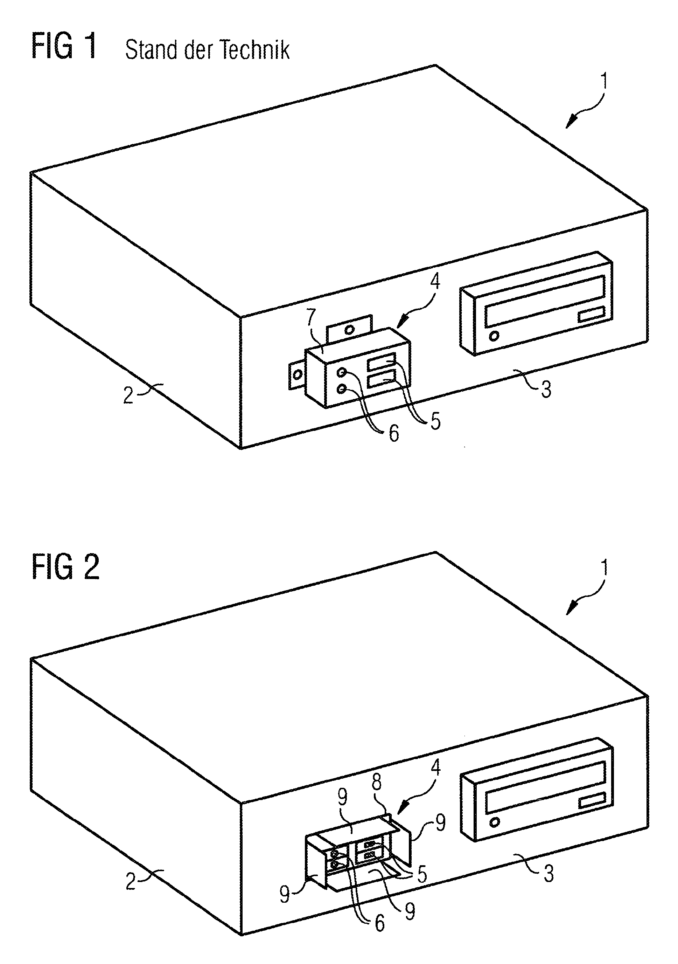

Figur 1 zeigt ein Computergehäuse 1 gemäß dem Stand der Technik. Das Computergehäuse 1 umfasst ein Chassis 2 aus einem elektrisch leitfähigen Material. Dabei handelt es sich in der Regel um ein oder mehrere gebogene und eventuell miteinander verschraubte oder vernietete Stahlblechteile. Im Bereich einer Vorderseite 3 ist ein Anschlussbereich 4 angeordnet. Im dargestellten Ausführungsbeispiel umfasst der Anschlussbereich 4 zwei so genannte USB-Anschlüsse 5 (Universal Serial Bus) sowie zwei Audioanschlüsse 6, beispielsweise einem Mikrofoneingang und einem Kopfhörerausgang. Zusätzlich kann das Computergehäuse 1 weitere Öffnungen aufweisen, beispielsweise zum Einbau von CD- oder anderen Laufwerke.

Die USB-Anschlüsse 5 und die Audioanschlüsse 6 des Anschlussbereiches 4 sind im Ausführungsbeispiel hinter einer Abschirmblende 7 angeordnet, deren Öffnungen genau an die Anschlüsse angepasst sind. Die Abschirmblende 7 verdeckt eine Öffnung in der Vorderseite 3 des Chassis 2, und schließt so das Chassis 2 nach vorne hin ab. Um die EMV-Dichtigkeit des Computergehäuses 1 im Bereich des Anschlussbereiches sicherzustellen, ist die Abschirmblende 7 aus einem elektrisch leitfähigen Material, beispielsweise Stahlblech, geformt. Die Abschirmblende 7 ist im dargestellten Ausführungsbeispiel auf die Vorderseite 3 geschraubt oder genietet, wodurch eine sichere elektrische Verbindung zwischen dem Chassis 2 und der Abschirmblende 7 hergestellt wird.

Vor der Abschirmblende 7 mit den darin integrierten Anschlüssen 5 und 6 wird im montierten Zustand des Computergehäuses 1 eine weitere Frontblende angeordnet, die im in der Figur 1 dargestellten Ausführungsbeispiel jedoch nicht dargestellt ist. Somit umfasst das Computergehäuse 1 gemäß Figur 1 wenigstens drei Komponenten im Bereich der Vorderseite 3: das Chassis 2 selbst, die Abschirmblende 7 sowie die nicht dargestellte Blende. Dabei müssen sowohl die Blende als auch das Abschirmblech 7 an die konkreten Anschlüsse 5 beziehungsweise 6 angepasst werden.

Figur 2 zeigt ein Computergehäuse 1 gemäß einer Ausgestaltung der Erfindung. Auch das Computergehäuse 1 gemäß der Figur 2 umfasst ein Chassis 2 mit einer Öffnung 8 im Bereich einer Vorderseite 3. Die Öffnung 8 dient zum Durchführen von Anschlüssen und Bedienelementen in einem Anschlussbereich 4. Im dargestellten Ausführungsbeispiel ist zu erkennen, dass in dem Computergehäuse 1 eine Platine mit darauf angeordneten USB-Anschlüssen 5 und Audioanschlüssen 6 angeordnet ist.

Anstelle einer Abschirmblende 7 umfasst das Computergehäuse 1 gemäß der Figur 2 vier Laschen 9, die die Öffnung 8 in alle vier Richtungen begrenzen. Die Laschen 9 sind aus der Vorderseite 3 des Chassis 2 herausgebogen und stehen nach vorne ab.

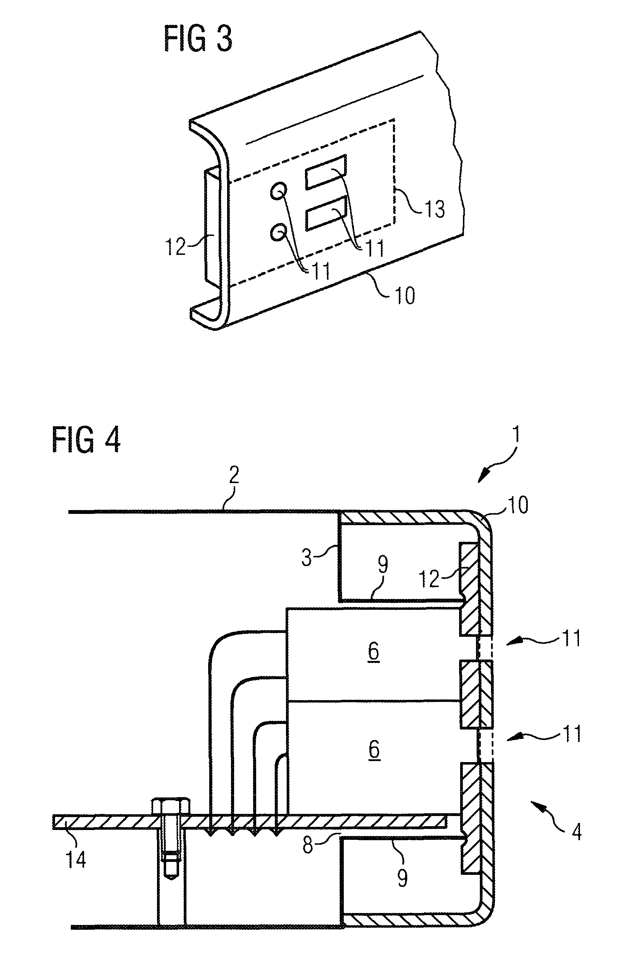

Figur 3 zeigt eine Blende 10, die zur Verwendung mit dem Computergehäuse 1 gemäß der Figur 2 geeignet ist. Die Blende 10 selber besteht aus einem elektrisch nicht leitfähigen Material, insbesondere Kunststoff, so dass sie auf besonders einfache und vielfältige Weise ausgestaltet werden kann. In die Blende 10 sind vier Öffnungen 11 eingearbeitet, die mit den USB-Anschlüssen 5 und den Audioanschlüssen 6 des Anschlussbereiches 4 korrespondieren. Des Weiteren ist auf der Rückseite der Blende 10, also der dem Chassis 2 zugewandten Seite der Blende 10, eine Dichtung 12 aus einem elektrisch leitfähigen Material angeordnet. Bei der Dichtung 12 kann es sich beispielsweise um eine Dichtung aus einem Schaumstoffkern mit einem darauf angeordneten leitfähigen Drahtnetzgitter handeln oder um eine andere elektrisch leitfähigen Dichtungsmasse, beispielsweise bestehend aus einem elektrisch leitfähigen Polymer-Material.

Die Dichtung 12 ist in einem Bereich 13 der Blende 10 angeordnet, der mit der Öffnung 8 des Chassis 2 korrespondiert. Wird die Blende 10 im Bereich der Vorderseite 3 des Computergehäuses angeordnet, kontaktieren die Laschen 9 somit die Dichtung 12 und stellen eine elektrische Verbindung zwischen diesen Elementen her. Auf diese Weise wird die EMV-Dichtigkeit des Gehäuses 1 durch ein Aufsetzen der Blende 10 mit der darauf aufgebrachten Dichtung 12 für den Anschlussbereich 4 hergestellt.

Figur 4 zeigt einen Querschnitt durch einen Anschlussbereich 4 eines fertig montierten Computergehäuse 1 gemäß einer Ausgestaltung der Erfindung. Das Computergehäuse 1 umfasst ein Chassis 2 mit einer in eine Vorderseite 3 integrierten Öffnung 8 für den Anschlussbereich 4. Vor der Vorderseite 3 ist eine Blende 10 angeordnet. Die Blende 10 weist im dargestellten Ausführungsbeispiel zwei Öffnungen 11 auf, durch die zwei Anschlüsse, im Ausführungsbeispiel Audioanschlüsse 6, hindurch geführt werden. Beispielsweise kann es sich dabei um so genannte 3,5 mm Klinkensteckerbuchsen handeln.

Aus der Vorderseite 3 des Chassis 2 sind zwei Laschen 9 herausgebogen, die fast bis an die Rückseite der Blende 10 heranreichen. Auf der Rückseite der Blende 10, also der den Laschen 9 zugewandten Seite, ist eine Dichtung 12 angeordnet, die im Ausführungsbeispiel aus einem elastischen, elektrisch leitfähigen Material besteht. Die Dichtung 12 kontaktiert die vorderen Enden der Laschen 9 und stellt somit eine elektrische Verbindung zwischen dem Chassis 2 und der Dichtung 12 her. Des Weiteren schließt die Dichtung 12 im Bereich der Öffnungen 11 formschlüssig mit den Audioanschlüssen 6 ab, so dass das Computergehäuse 1 im Anschlussbereich 4 elektromagnetisch abgedichtet ist.

In einer vorteilhaften Ausgestaltung sind die Gehäuse der Audioanschlüsse 6 zusätzlich mit einem elektrischen Massepotential verbunden, so dass über einen Kragenbereich der Audioanschlüsse 6 ein zusätzlicher Massekontakt zwischen dem Computergehäuse 1 und der Dichtung 12 hergestellt wird.

Im in der Figur 4 dargestellten Ausführungsbeispiel sind die Audioanschlüsse 6 direkt auf einer Hauptplatine 14 angeordnet, so dass der Montageaufwand für das Computersystem minimiert wird. Nach Einsetzen der Hauptplatine 12 in das Chassis 2 muss lediglich ein passende Frontblende 10 mit darauf angebrachter Dichtung 12 auf die Vorderseite 3 des Chassis 2 aufgesetzt werden, um sowohl die elektrische Funktion der Anschlüsse 6 als auch die EMV-Dichtigkeit des Computergehäuses 1 herzustellen. Auf diese Weise wird die Herstellung und Montage eines Computersystems besonders einfach gestaltet.

Anstelle der USB-Anschlüsse 5 oder der Audioanschlüsse 6 können in dem Anschlussbereich 4 auch Bedienelemente vorgesehen sein. Beispiele für solche Bedienelemente sind Taster oder Schalter zum Einschalten des Computersystems oder zum Schalten des Computersystems in einen Energiesparzustand. Darüber hinaus können auch Anzeigeelemente in der Form von Statusanzeigen, beispielsweise LCD- oder LED-Anzeigen vorgesehen sein.

In diesem Fall muss die Blende 10 nicht notwendigerweise über Öffnungen 11 in dem Anschlussbereich 4 verfügen. Anstelle der Öffnungen 11 können dann flexible oder durchscheinende Elemente der Blende 10 treten, die eine Bedienung der Bedienelemente beziehungsweise ein Anzeigen von Statusinformationen durch die Blende 10 hindurch gestatten. Auch in einer solchen Ausgestaltung wird sowohl die Montage des Computergehäuses 1, als auch dessen elektromagnetische Dichtigkeit durch Verwendung einer Dichtung 12 in dem Anschlussbereich 4 vereinfacht beziehungsweise verbessert.

Selbstverständlich ist die Erfindung nicht auf eine Anwendung im Bereich einer Vorderseite 3 eines Chassis 2 beschränkt. Eine Anwendung ist in praktisch jedem Bereich eines verblendeten Gehäuses möglich, das auf einfache Weise elektromagnetisch abgeschirmt werden soll.

### Bezugszeichenliste

- 1: Computergehäuse
- 2: Chassis
- 3: Vorderseite
- 4: Anschlussbereich
- 5: USB-Anschluss
- 6: Audioanschluss
- 7: Abschirmblech
- 8: Öffnung
- 9: Lasche
- 10: Blende
- 11: Öffnung
- 12: Dichtung
- 13: Bereich
- 14: Hauptplatine

## Patentansprüche

1. Computergehäuse (1), umfassend ein Chassis (2) aus einem elektrisch leitfähigen Material mit wenigstens einer Öffnung (8) in einer ersten Seite (3) des Chassis (2) und eine Blende (10), die vor der ersten Seite (3) des Chassis (2) und im Bereich der wenigstens einen Öffnung (8) angeordnet ist,
**dadurch gekennzeichnet, dass**
die Blende (10) aus einem elektrisch nicht leitfähigen Material hergestellt ist, das Chassis (2) im Bereich der Öffnung (8) wenigstens eine in Richtung der Blende (10) aus der ersten Seite (3) herausgebogene und nach vorne abstehende Lasche (9) aufweist und auf einer dem Chassis (2) zugewandten Seite der Blende (10) wenigstens eine elektrisch leitfähige Dichtung (12) im Bereich der Öffnung (8) des Chassis (2) angeordnet ist, wobei die Dichtung (12) im elektrischen Kontakt mit der wenigstens einen Lasche (9) steht, um eine elektrische Schirmung des Computergehäuses (1) im Bereich der Öffnung (8) zu bewirken.

2. Computergehäuse (1) nach Anspruch 1,
**dadurch gekennzeichnet, dass**
die elektrisch leitfähige Dichtung (12) ein elastisches Schaumstoffteil mit einer elektrisch leitfähigen Oberfläche oder ein elektrisch leitfähiges Polymer-Material umfasst.

3. Computergehäuse (1) nach Anspruch 1 oder 2,
**dadurch gekennzeichnet, dass**
wenigstens ein Bedienelement im Bereich der Öffnung (8) vorgesehen ist und die Blende (10) im Bereich des wenigstens einen Bedienelementes zumindest teilweise flexibel ausgestaltet ist, so dass das Bedienelement durch die Blende (10) hindurch bedient werden kann.

4. Computergehäuse (1) nach einem der Ansprüche 1 bis 3,
**dadurch gekennzeichnet, dass**
wenigstens ein Anzeigeelement im Bereich der Öffnung (8) vorgesehen ist und die Blende (10) im Bereich des wenigstens einen Anzeigeelementes zumindest teilweise durchscheinend ausgestaltet ist, so dass das Anzeigeelement durch die Blende (10) hindurch abgelesen werden kann.

5. Computergehäuse (1) nach einem der Ansprüche 1 bis 4,
**dadurch gekennzeichnet, dass**
in der Blende (10) und der elektrisch leitfähigen Dichtung (12) wenigstens eine Öffnung (11) zur Durchführung eines Anschlusses (5, 6), eines Anzeigeelementes oder eines Bedienelementes angeordnet sind, wobei die elektrisch leitfähigen Dichtung (12) formschlüssig mit dem Anschluss (5, 6), dem Anzeigelement beziehungsweise dem Bedienelement abschließt.

6. Computergehäuse (1) nach Anspruch 5,
**dadurch gekennzeichnet, dass**
in der Blende (10) und der elektrisch leitfähigen Dichtung (12) eine Mehrzahl von Öffnungen (11) für eine Mehrzahl von Anschlüssen (5, 6), Anzeigeelementen und/oder Bedienelementen angeordnet sind und in dem Chassis (2) eine einzelne Öffnung (8) zum Durchführen der Mehrzahl von Anschlüssen (5, 6), Anzeigeelementen beziehungsweise Bedienelementen vorgesehen ist.

7. Computergehäuse (1) nach einem der Ansprüche 3 bis 6,
**dadurch gekennzeichnet, dass**
die Öffnung (8) des Chassis (2) und die Blende (10) auf einer Vorderseite (3) des Computergehäuses (1) angeordnet sind, so dass wenigstens ein Anschluss (5, 6), ein Anzeigeelement und/oder ein Bedienelement für einen Benutzer des Computersystems (1) zugänglich ist.

8. Computergehäuse (1) nach einem der Ansprüche 1 bis 6,
**dadurch gekennzeichnet dass**,
die Öffnung (8) des Chassis (2) von einer Mehrzahl von Laschen (9) umgeben ist, die einen elektrischen Kontakt zwischen der Dichtung (12) und dem Chassis (2) an verschiedenen Punkten herstellen.

## Claims

1. Computer housing (1) comprising a chassis (2) which is composed of an electrically conductive material and has at least one opening (8) in a first side (3) of the chassis (2) and a panel (10) which is arranged in front of the first side (3) of the chassis (2) and in the region of the at least one opening (8), **characterized in that** the panel (10) is produced from an electrically non-conductive material, the chassis (2) has at least one lug (9), which is bent out of the first side (3) and projects forwards in the direction of the panel (10), in the region of the opening (8), and at least one electrically conductive seal (12) is arranged in the region of the opening (8) in the chassis (2) on a side of the panel (10) which faces the chassis (2), wherein the seal (12) is in electrical contact with the at least one lug (9) in order to create an electrical shield for the computer housing (1) in the region of the opening (8).

2. Computer housing (1) according to Claim 1, **characterized in that** the electrically conductive seal (12) comprises an elastic foam part with an electrically conductive surface or an electrically conductive polymer material.

3. Computer housing (1) according to Claim 1 or 2, **characterized in that** at least one operator control element is provided in the region of the opening (8) and the panel (10) is designed to be at least partially flexible in the region of the at least one operator control element, so that the operator control element can be operated through the panel (10).

4. Computer housing (1) according to one of Claims 1 to 3, **characterized in that** at least one indicator element is provided in the region of the opening (8) and the panel (10) is designed to be at least partially transparent in the region of the at least one indicator element, so that the indicator element can be read through the panel (10).

5. Computer housing (1) according to one of Claims 1 to 4, **characterized in that** at least one opening (11) through which a connection (5, 6), an indicator element or an operator control element can be routed is arranged in the panel (10) and the electrically conductive seal (12), wherein the electrically conductive seal (12) terminates in a form-fitting manner with the connection (5, 6), the indicator element or the operator control element.

6. Computer housing (1) according to Claim 5, **characterized in that** a plurality of openings (11) for a plurality of connections (5, 6), indicator elements and/or operator control elements are arranged in the panel (10) and the electrically conductive seal (12), and a single opening (8) through which the plurality of connections (5, 6), indicator elements or operator control elements can be routed is provided in the chassis (2).

7. Computer housing (1) according to one of Claims 3 to 6, **characterized in that** the opening (8) in the chassis (2) and the panel (10) are arranged on a front face (3) of the computer housing (1), so that at least one connection (5, 6), one indicator element and/or one operator control element are/is accessible to a user of the computer system (1).

8. Computer housing (1) according to one of Claims 1 to 6, **characterized in that** the opening (8) in the chassis (2) is surrounded by a plurality of lugs (9) which establish electrical contact between the seal (12) and the chassis (2) at various points.

## Revendications

1. Boîtier d'ordinateur (1), comprenant un châssis (2) composé d'un matériau électriquement conducteur avec au moins une ouverture (8) pratiquée dans un premier côté (3) du châssis (2) et un diaphragme (10), disposé devant le premier côté (3) du châssis (2) et disposé dans la région de l'au moins une ouverture (8), **caractérisé en ce que** le diaphragme (10) est fabriqué à partir d'un matériau électriquement non conducteur, que le châssis (2) comporte au moins une bride (9) incurvée vers l'extérieur en partant du premier côté (3) et en direction du diaphragme (10) dans la région de l'ouverture (8) et saillant vers l'avant et qu'au moins un joint d'étanchéité (12) électriquement conducteur est disposé sur un côté du diaphragme (10) orienté vers le châssis (2) dans la région de l'ouverture (8) du châssis (2), le joint d'étanchéité (12) étant en contact électrique avec l'au moins une bride (9) pour provoquer un blindage électrique du boîtier d'ordinateur (1) dans la région de l'ouverture (8).

2. Boîtier d'ordinateur (1) selon la revendication 1, **caractérisé en ce que** le joint d'étanchéité (12) électriquement conducteur comprend une pièce en mousse élastique dotée d'une surface électriquement conductrice ou d'un matériau en polymère électriquement conducteur.

3. Boîtier d'ordinateur (1) selon la revendication 1 ou 2, **caractérisé en ce qu'**au moins un élément de commande est prévu dans la région de l'ouverture (8) et que le diaphragme (10) est configuré de façon au moins en partie flexible dans la région de l'au moins un élément de commande, de sorte que l'élément de commande peut être utilisé à travers le diaphragme (10).

4. Boîtier d'ordinateur (1) selon l'une quelconque des revendications 1 à 3, **caractérisé en ce qu'**au moins un élément d'affichage est prévu dans la région de l'ouverture (8) et que le diaphragme (10) est conçu de façon au moins en partie transparente dans la région de l'au moins un élément d'affichage, de sorte que l'élément d'affichage peut être lu à travers le diaphragme (10).

5. Boîtier d'ordinateur (1) selon l'une quelconque des revendications 1 à 4, **caractérisé en ce qu'**au moins une ouverture (11) permettant le passage d'un raccord (5, 6), d'un élément d'affichage ou d'un élément de commande est disposée dans le diaphragme (10) et dans le joint d'étanchéité (12) électriquement conducteur, le joint d'étanchéité (12) électriquement conducteur se terminant par complémentarité de formes par le raccord (5, 6), l'élément d'affichage et/ou l'élément de commande.

6. Boîtier d'ordinateur (1) selon la revendication 5, **caractérisé en ce qu'**une pluralité d'ouvertures (11) prévues pour une pluralité de raccords (5, 6), d'éléments d'affichage et/ou d'éléments de commande sont disposées dans le diaphragme (10) et dans le joint d'étanchéité (12) électriquement conducteur et qu'une ouverture individuelle (8) permettant de faire passer la pluralité de raccords (5, 6), d'éléments d'affichage et/ou d'éléments de commande est prévue dans le châssis (2).

7. Boîtier d'ordinateur (1) selon l'une quelconque des revendications 3 à 6, **caractérisé en ce que** l'ouverture (8) du châssis (2) et le diaphragme (10) sont disposés sur un côté avant (3) du boîtier d'ordinateur (1), de sorte qu'au moins un raccord (5, 6), un élément d'affichage et/ou un élément de commande peuvent être accessibles à un utilisateur du système informatique (1).

8. Boîtier d'ordinateur (1) selon l'une quelconque des revendications 1 à 6, **caractérisé en ce que** l'ouverture (8) du châssis (2) est entourée par une pluralité de brides (9) établissant un contact électrique en différents points entre le joint d'étanchéité (12) et le châssis (2).
